# EUROPEAN PATENT APPLICATION

(11) **EP 4 462 479 A1**
(43) Date of publication of application: **13.11.2024**
(21) Application number: 23183978.8
(22) Date of filing: 06.07.2023
(51) Int. Cl.: H01L 23/498, H01L 23/50

(54) **SEMICONDUCTOR PACKAGE WITH TWO SUBSTRATES**

(30) Priority: 09.05.2023 US 202318314469
(71) Applicant: Juniper Networks, Inc., Sunnyvale, CA 94089 (US)
(72) Inventor: HUTCHINSON, Leif, Sunnyvale, 94089 (US); PREZIOSO, Daniel J., Sunnyvale, 94089 (US); REYNOV, Boris, Sunnyvale, 94089 (US)
(74) Representative: D Young & Co LLP

(57) **Abstract**

A semiconductor package includes a first substrate having a top surface and a bottom surface, and a second substrate having a top surface and a bottom surface. The bottom surface of the first substrate is connected to the top surface of the second substrate via at least one bonding layer. The first substrate includes one or more electrically conductive components arranged on the bottom surface of the first substrate in a first pattern. The second substrate includes one or more slots arranged on the bottom surface of the second substrate in a second pattern. The one or more slots are each plated with an electrically conductive material. The arrangement of the one or more electrically conductive components in the first pattern is aligned with the arrangement of the one or more slots in the second pattern. The second substrate includes a stiffener disposed within the second substrate.

## Description

### BACKGROUND

A semiconductor package includes one or more semiconductor devices, such as one or more integrated circuits. Semiconductor device components may be fabricated on semiconductor wafers, diced into dies, and then packaged. In some cases, a semiconductor package may include elements, such as balls, pins, or leads, for connecting components of the semiconductor package to an external component (e.g., a circuit board).

### SUMMARY

Particular embodiments are set out in the independent claims. Various optional examples are set out in the dependent claims. In some implementations, a semiconductor package includes a first substrate having a top surface and a bottom surface; and a second substrate having a top surface and a bottom surface, wherein: the bottom surface of the first substrate is connected to the top surface of the second substrate via at least one bonding layer; the first substrate includes one or more electrically conductive components arranged on the bottom surface of the first substrate in a first pattern; the second substrate includes one or more slots arranged on the bottom surface of the second substrate in a second pattern, the one or more slots are each plated with an electrically conductive material; and the arrangement of the one or more electrically conductive components in the first pattern is aligned with the arrangement of the one or more slots in the second pattern.

In some implementations, a semiconductor package includes a first substrate having a top surface and a bottom surface; and a second substrate having a top surface and a bottom surface, wherein: the bottom surface of the first substrate is connected to the top surface of the second substrate via at least one bonding layer; the second substrate includes one or more slots on the bottom surface of the second substrate, wherein each slot, of the one or more slots, extends through the second substrate and the at least one bonding layer; the one or more slots are each plated with an electrically conductive material; and the second substrate includes a stiffener disposed within the second substrate.

In some implementations, a semiconductor package includes a first substrate having a top surface and a bottom surface; and a second substrate having a top surface and a bottom surface, wherein: the bottom surface of the first substrate is connected to the top surface of the second substrate via at least one bonding layer; the second substrate includes one or more slots on the bottom surface of the second substrate that are each plated with an electrically conductive material; and the second substrate includes a stiffener disposed within the second substrate.

### BRIEF DESCRIPTION OF THE DRAWINGS

Figs. 1A-1E show different views of an example implementation of a semiconductor package.
Fig. 2 is a diagram of example components of a device, which may correspond to the semiconductor package and/or the semiconductor device.

### DETAILED DESCRIPTION

The following detailed description of example implementations refers to the accompanying drawings. The same reference numbers in different drawings may identify the same or similar elements.

A semiconductor package may be mounted to a circuit board by one or more physical connections, such as by solder connections. For example, the semiconductor package may include a ball grid array (BGA) that facilitates connection of the semiconductor package and a circuit board by numerous solder connections (e.g., solder joints). In some cases, the semiconductor package may have a tendency to flex or bow due to temperature changes resulting from operation of the semiconductor package. This can create significant stress on the solder connections. When solder connections between the semiconductor package and the circuit board are unreliable and/or unable to withstand frequent temperature changes, damage (e.g., fracturing) to the solder connections can occur. Damage to one or more solder connections may affect the exchange of electrical signals between the semiconductor package and the circuit board, thereby impairing a functionality of the semiconductor package.

In some cases, a stiffener component (e.g., made from an inflexible material) can be placed on a top surface of the semiconductor package to reduce flexing or bowing of the semiconductor package, but this can create more stress on the solder connections and thereby increase a likelihood of impairing the functionality of the semiconductor package. Further, the stiffener reduces an amount of available space on the top surface of the semiconductor package that is available for processing and communication components. As a need for "high-speed" processing and communication continues to increase, which requires more and larger high-speed components, space at the top surface of the semiconductor package is at a premium. Continuing to use a stiffener component on the top surface of the semiconductor package is no longer practical for many applications.

Further, because the solder joints must serve a mechanical function (e.g., to prevent or minimize flexing or bowing), the solder joints typically do not provide a good electrical connection (e.g., as compared to a typical electrical connection). This can result in power losses when transmitting electrical power, such as from the circuit board to the semiconductor package, which further impairs a functionality of the semiconductor package.

Some implementations described herein provide a semiconductor package that includes a first substrate and a second substrate (e.g., semiconductor package with two substrates), each including a top surface and a bottom surface. The first substrate includes one or more electrically conductive components (e.g., comprising at least a metal, such as copper) arranged on the bottom surface of the first substrate. The second substrate includes one or more slots arranged on the bottom surface of the second substrate. The one or more slots are each plated with an electrically conductive material (e.g., at least a metal, such as copper) and extend (e.g., vertically) through the second substrate. Accordingly, the one or more electrically conductive components may be arranged to be aligned with the one or more slots, and may therefore be electrically connected, such as through sets of electrically conductive layers (e.g., that comprise at least a metal, such as copper) of the first substrate and the second substrate.

In this way, a low-loss, electrically conductive path (e.g., that comprises at least a metal, such as copper) is provided from the second substrate to the first substrate, and therefore to one or more components (e.g., one or more semiconductor devices or other components) on the top surface of the first substrate. This reduces an amount of loss during transmission of electrical power (as compared to using solder joints), and therefore provides an improved functionality of the semiconductor package. This enables safe, efficient use of the semiconductor package for high-power applications.

Further, the semiconductor package allows a power supply component to be disposed on (e.g., to physically contact) the second substrate. So, electrical power can be supplied to the semiconductor package without the need for any solder joints. This further improves the functionality of the semiconductor package. Additionally, reducing (or eliminating) a number of solder reflows that are needed to form the semiconductor package reduces a number of extreme temperature cycles incurred by the semiconductor package during formation of the semiconductor package, which reduces a likelihood of damage to the semiconductor package and thereby improves an operable life of the semiconductor package.

Further, the bottom surface of the first substrate may be laminated to the top surface of the second substrate (e.g., via at least one bonding layer), which provides a more physically robust "super substrate." Additionally, the second substrate includes a stiffener disposed within the second substrate (e.g., integrated within the second substrate, not on an external surface of the semiconductor package). Thus, the stiffener improves a resistance of the semiconductor package to flexing or bowing (e.g., due to temperature fluctuations) and does not occupy space on a top surface of the semiconductor package. Accordingly, more and larger components (e.g., semiconductor devices, cable connections, and/or other components that enable high-speed processing and connections) may be disposed on the top surface of the semiconductor package. This enables the semiconductor package to be used in many applications where using a semiconductor package with a non-integrated stiffener component is not practical.

Moreover, in some implementations, the semiconductor package includes a heatsink on the second substrate. This allows for excess heat to be transferred away from the semiconductor package. Including a heatsink on a typical semiconductor package is not practical because surfaces of the semiconductor package need to connect to other components via solder joints. In this way, the semiconductor package described herein provides an improved thermal performance.

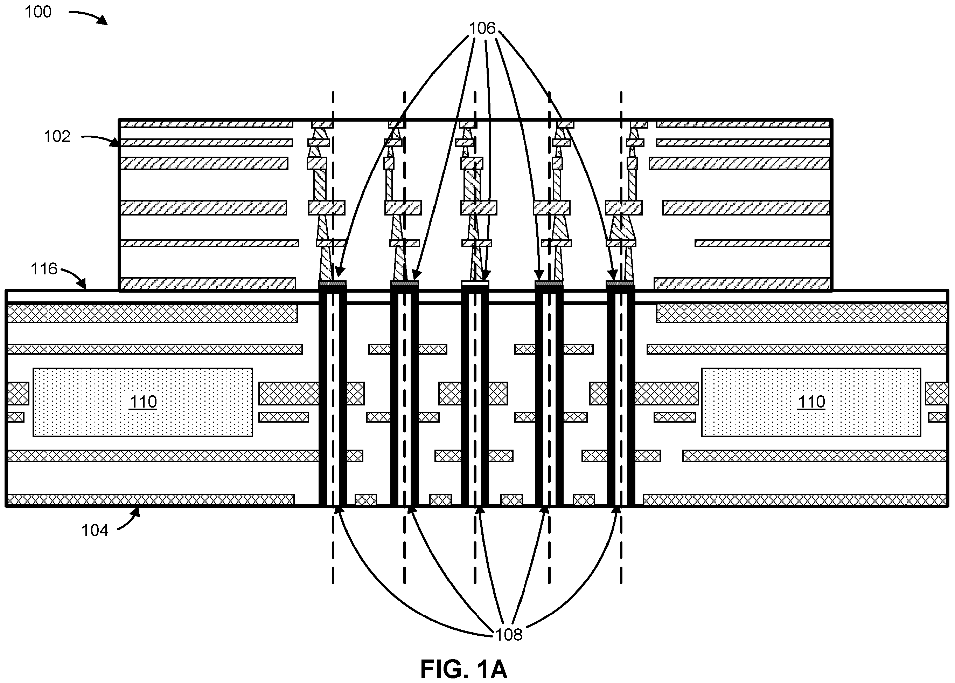

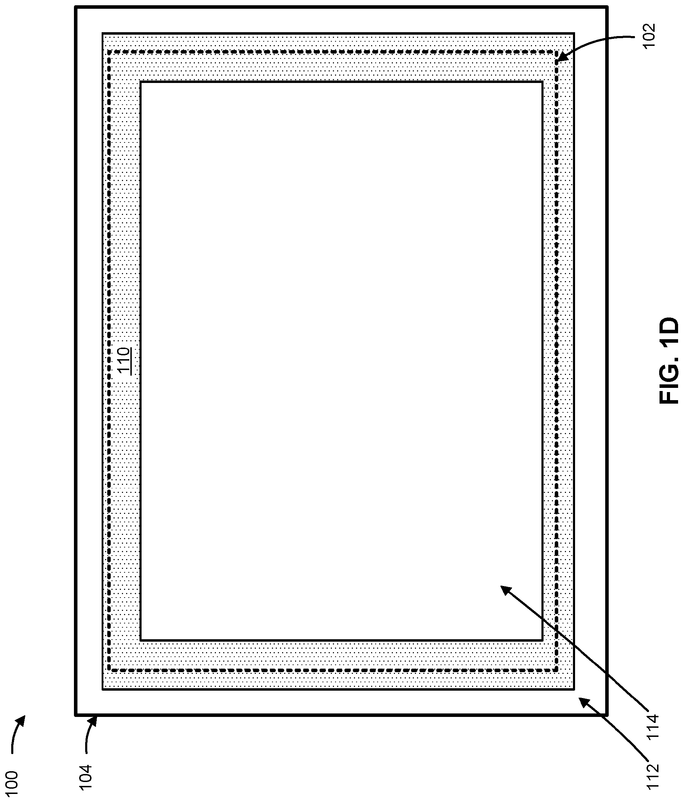

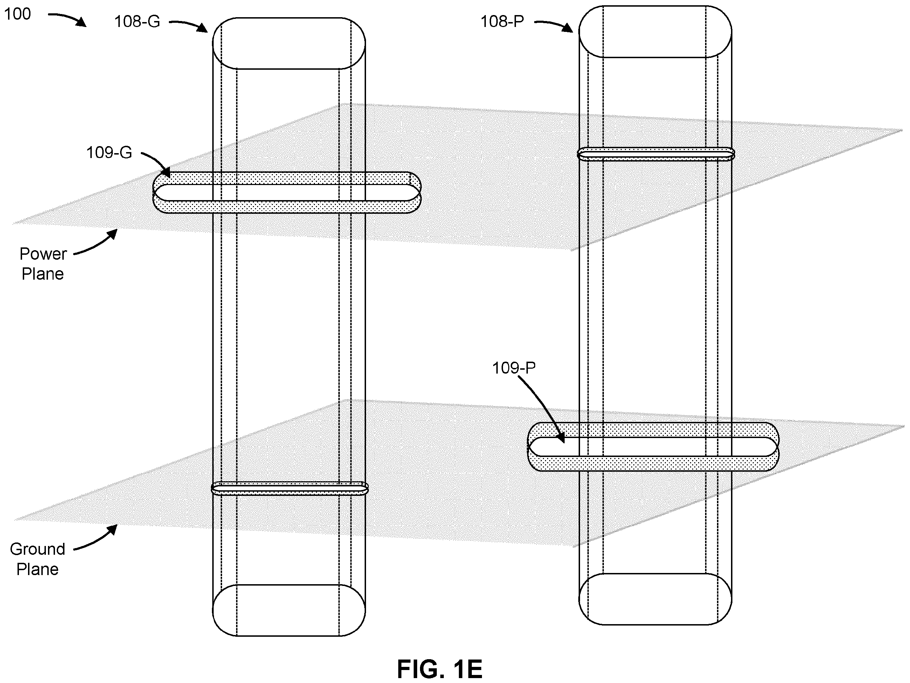

Figs. 1A-1E show different views of an example implementation of a semiconductor package 100 (which may also be referred to as a semiconductor device assembly). The semiconductor package 100 may include a first substrate 102 and a second substrate 104. Figs. 1A-1C show side, cross-sections of different configurations of the semiconductor package 100, Fig. 1D shows a top perspective view of a configuration of the semiconductor package 100, and Fig. 1E shows examples of one or more slots (e.g., one or more slots 108, described herein) of the semiconductor package 100.

The first substrate 102 may have a top surface and a bottom surface. The first substrate 102 may include a conductive or semi-conductive material (e.g., silicon, aluminum, and/or copper, among other examples), may include a printed circuit board (PCB) material, and/or may include another material. In some implementations, the first substrate 102 may include a set of layers, such as one or more electrically conductive layers (shown in Figs. 1A-1C with diagonal, left-to-right patterning) and one or more dielectric layers (shown in Figs. 1A-1C without any patterning) (e.g., stacked in an alternating order). The one or more electrically conductive layers may each include, for example, at least a metal, such as tungsten, copper, silver, and/or gold, or another electrically conductive material. The one or more dielectric layers may each include, for example, at least a ceramic material, a polyimide material, an epoxy material, an aluminum material, and/or another dielectric material. The first substrate 102 may include one or more vias (e.g., one or more micro-vias, one or more buried vias, and/or one or more other types of vias, shown in Figs. 1A-1C with diagonal, right-to-left patterning). Each via may extend through at least one of the one or more dielectric layers to electrically connect electrically conductive layers. Each via may include, for example, at least a metal, such as tungsten, copper, silver, and/or gold, or another electrically conductive material. The one or more electrically conductive layers may be patterned to allow for separate electrical paths through the first substrate 102 (e.g., using the one or more vias).

In some implementations, the top surface of the first substrate 102 may comprise a first electrically conductive layer (e.g., a top-most electrically conductive layer with diagonal, left-to-right patterning) and the bottom surface of the first substrate 102 may comprise a second electrically conductive layer (e.g., a bottom-most electrically conductive layer with diagonal, left-to-right patterning). The first substrate 102 may be sized and shaped (e.g., rectilinear and planar) to support one or more other components (e.g., one or more semiconductor devices 118 and/or one or more cable connection components 120, described further herein) on the top surface of the first substrate 102.

In some implementations, the first substrate 102 may include one or more electrically conductive components 106 (shown in Figs. 1A-1C with patterned black shading). The one or more electrically conductive components 106 may comprise an electrically conductive material (e.g., that includes at least a metal, such as tungsten, copper, silver, and/or gold, or another electrically conductive material). The one or more electrically conductive components 106 may be included in, or may be electrically connected to, at least one electrically conductive layer of the one or more electrically conductive layers (e.g., the bottom-most electrically conductive layer of the first substrate 102), or may be separate components. In some implementations, the one or more electrically conductive components 106 may be arranged on the bottom surface of the first substrate 102 in a first pattern. The first pattern may be a regular pattern, such as an array (e.g., a one-dimensional array or a two-dimensional array), or another pattern.

The second substrate 104 may have a top surface and a bottom surface. The second substrate 104 may include a conductive or semi-conductive material (e.g., silicon, aluminum, and/or copper, among other examples), may include a PCB material, and/or may include another material. In some implementations, the second substrate 104 may include a set of layers, such as one or more electrically conductive layers (shown in Figs. 1A-1C with diamond patterning) and one or more dielectric layers (shown in Figs. 1A-1C without any patterning) (e.g., stacked in an alternating order). The one or more electrically conductive layers may each include, for example, at least a metal, such as tungsten, copper, silver, and/or gold, or another electrically conductive material. The one or more dielectric layers may each include, for example, at least a ceramic material, a polyimide material, an epoxy material, an aluminum material, and/or another dielectric material. The one or more electrically conductive layers may be patterned to allow for separate electrical paths through the second substrate 104 (e.g., as described herein).

In some implementations, the top surface of the second substrate 104 may comprise a first electrically conductive layer (e.g., a top-most electrically conductive layer with diamond patterning) and the bottom surface of the second substrate 104 may comprise a second electrically conductive layer (e.g., a bottom-most electrically conductive layer with diamond patterning). The second substrate 104 may be sized and shaped (e.g., rectilinear and planar) to support one or more other components (e.g., the first substrate 102 and/or a power supply component 122, as further described herein) on the top surface of the second substrate 104.

In some implementations, the first substrate 102 may include a first set of layers that are associated with a first set of materials (e.g., the first set of layers comprises a first set of electrically conductive materials and a first set of dielectric materials) and the second substrate 104 may include a second set of layers that are associated with a second set of materials (e.g., the second set of layers comprises a second set of electrically conductive materials and a second set of dielectric materials). The first set of materials may be different than the second set of materials. For example, the first set of materials may include a material (e.g., an electrically conductive material) that is not included in the second set of materials, or vice versa. In this way, the first substrate 102 and the second substrate 104 may be said to have a different composition.

In some implementations, the second substrate 104 may include one or more slots 108. The one or more slots 108 may be milled slots, etched slots, or other types of slots. As shown in Figs. 1A-1C, the one or more slots 108 may extend (e.g., extend vertically) through the second substrate 104. For example, each slot 108 may extend from the bottom surface of the second substrate 104 to the top surface of the second substrate 104. In some implementations, the one or more slots 108 may extend from the bottom surface of the second substrate 104 to the top surface of the second substrate 104, and therefore may form channels, vias, or other similar structures in the second substrate 104.

Each slot 108 may include an electrically conductive material (e.g., that includes at least a metal, such as tungsten, copper, silver, and/or gold, or another electrically conductive material) disposed within the slot 108 (e.g., within an internal environment of the slot 108). For example, as shown in Figs. 1A-1C, each slot 108 may be plated (e.g., on one or more interior surfaces of the slot 108) with an electrically conductive material (shown with solid black shading).

In some implementations, the one or more slots 108 may be arranged on the bottom surface of the second substrate 104 in a second pattern. The second pattern may be a regular pattern, such as an array (e.g., a one-dimensional array or a two-dimensional array), or another pattern. For example, the one or more slots 108 may be arranged in an offset two-dimensional array pattern (e.g., a "checkerboard" pattern). In some implementations, the arrangement of the one or more electrically conductive components 106 in the first pattern may be aligned with the arrangement of the one or more slots 108 in the second pattern. This may allow, for example, as shown in Fig. 1A, an electrically conductive component 106 (e.g., arranged in the first pattern) and a slot 108 (e.g., arranged in the second pattern) to be aligned (e.g., vertically aligned, as shown by a dashed vertical line).

In some implementations, a slot 108 may have a particular type or characteristic. For example, as shown in Fig. 1E, a slot 108 may be a grounded slot 108-G or a powered slot 108-P. A grounded slot 108-G may be configured to provide grounding for the second substrate 104 (and/or the semiconductor package 100) and may be connected to a ground plane within the second substrate 104. A powered slot 108-P may be configured to provide electrical power for the second substrate 104 (and/or the semiconductor package 100) and may be connected to a power plane within the second substrate 104. Accordingly, a first clearance void 109-G may be formed around the grounded slot 108-G in the power plane, and a second clearance void 109-P may be formed around the powered slot 108-P in the ground plane.

In some implementations, the second substrate 104 may include a stiffener 110 (which may also be referred to as a stiffener plate, a stiffener frame, a stiffener ring, or the like). The stiffener 110 may be disposed within the second substrate 104 (e.g., not disposed on an exterior surface, such as the top surface and the bottom surface, of the second substrate 104). For example, as shown in Figs. 1A-1C, the stiffener 110 may disposed between one or more portions of the set of layers of the second substrate 104. In some implementations, the stiffener 110 may be integrated into the second substrate 104 using one or more milling techniques, one or more etching techniques, and/or one or more coining techniques, among other examples. The stiffener 110 may comprise a rigid material that includes at least silicon, one or more metals (e.g., aluminum, copper, and/or another metal, among other examples), a polymeric material (e.g., silicone rubber mixed with aluminum particles and zinc oxide), and/or another material.

In some implementations, the stiffener 110 may be configured to minimize warpage of the semiconductor package 100. For example, the stiffener 110 may be configured to cause warpage of the semiconductor package 100 during operation of the semiconductor package 100 (e.g., due to temperature fluctuations created by operation of the semiconductor package 100) to be less than or equal to a warpage threshold. The warpage threshold may be, for example, less than or equal to 100 micrometers (µm), 150 µm, 200 µm, 250 µm, 300 µm, 350 µm, or 400 µm.

In some implementations, such as shown in Fig. 1D, the stiffener 110 may be provided within the second substrate 104 and may be aligned with a first portion 112 (e.g., a perimeter portion) of the second substrate 104. Additionally, the stiffener may not be aligned with a second portion 114 (e.g., a central portion) of the second substrate 104. The second portion 114 of the second substrate 104 may be separate from (e.g., may not overlap with) the first portion 112 of the second substrate 104. Accordingly, the stiffener 110 may have a "frame" profile (e.g., a frame-like structure, such as shown in Fig. 1D), such that the stiffener 110 has an opening (e.g., a central opening). In some implementations, the one or more slots 108 may be arranged on the bottom surface of the second substrate 104 and may be aligned with the second portion 114 of the second substrate 104 (and may not be aligned with the first portion 112 of the second substrate 104). Accordingly, at least one of the one or more slots 108 may extend (e.g., extend vertically) through the opening of the stiffener 110.

In some implementations, the first substrate 102 may be disposed on the second substrate 104, such as shown in Figs. 1A-1D. For example, the bottom surface of the first substrate 102 may be disposed on (e.g., may physically contact) the top surface of the second substrate 104. Each of the bottom surface of the first substrate 102 and the top surface of the second substrate 104 may comprise an electrically conductive layer, and therefore the first substrate 102 and the second substrate 104 may be electrically connected when the first substrate 102 is disposed on the second substrate 104. In this way, a slot 108 of the second substrate 104 (e.g., due to the electrically conductive material within the slot 108) and a corresponding electrically conductive component 106 may be electrically connected through the bottom surface of the first substrate 102 and the top surface of the second substrate 104.

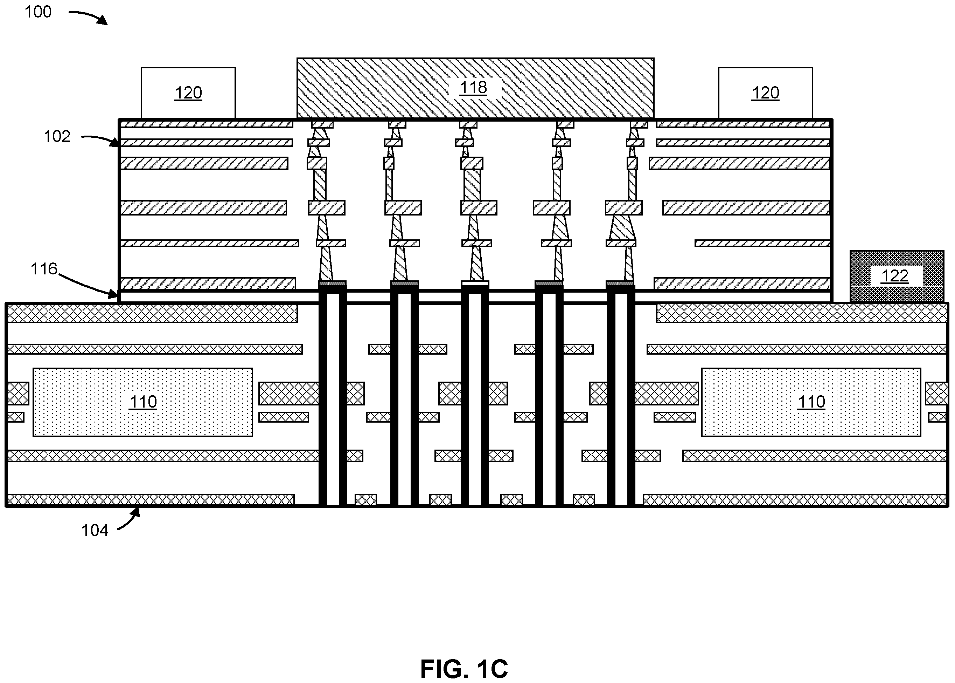

In some implementations, the bottom surface of the first substrate 102 and the top surface of the second substrate 104 may be laminated together. For example, as shown in Figs. 1C, at least one bonding layer 116 (also referred to as at least one laminating layer) may be disposed between the first substrate 102 and the second substrate 104, and may be configured to bond the first substrate 102 to the second substrate 104 (e.g., to bond the bottom surface of the first substrate 102 to the top surface of the second substrate 104). In this way, the first substrate 102 and the second substrate 104 may be mechanically connected (e.g., via the at least one bonding layer 116) to form a "super" substrate (e.g., a single, unified substrate). The at least one bonding layer 116 may be a dielectric layer and may include, for example, at least a ceramic material, a polyimide material, an epoxy material, an aluminum material, and/or another dielectric material.

In some implementations, the one or more slots 108 may extend (e.g., such as from the second substrate 104) through the at least one bonding layer 116, and may also extend through a portion of the first substrate 102. For example, as shown in Figs. 1A-1C, the one or more slots 108 may extend (e.g., extend vertically) through the at least one bonding layer 116, and may extend into the first substrate 102 (e.g., into the one or more electrically conductive components 106). As described above, each slot 108 may include an electrically conductive material (e.g., may be plated with the electrically conductive material). In this way, each slot 108 may provide an electrical path that extends through the second substrate 104, the at least one bonding layer 116, and connects to a corresponding path in the first substrate 102 (e.g., formed from portions of the one or more electrically conductive layers and one or more vias of the first substrate 102).

As shown in Fig. 1C, the semiconductor package 100 may include one or more semiconductor devices 118, which may be disposed on (e.g., may physically contact) the top surface of the first substrate 102. The one or more semiconductor devices 118 may be disposed on a portion (e.g., a central portion) of the top surface of the first substrate 102. The one or more semiconductor devices 118 may be electrically connected to the first substrate 102 (e.g., by flip-chip bonding and/or by wire bonding).

A semiconductor device 118 may include one or multiple semiconductor dies (e.g., in a stacked arrangement). A semiconductor device 118 may include an integrated circuit chip. In some implementations, a semiconductor device 118 may include an application specific integrated circuit (ASIC), which may include an integrated circuit chip that is customized for a particular use, rather than intended for a general-purpose use. Additionally, or alternatively, a semiconductor device 118 may include an application-specific standard product (ASSP) chip or an industry standard integrated circuit chip, among other examples. Additionally, or alternatively, a semiconductor device 118 may include a memory device (e.g., a device configured to store information), such as a high bandwidth memory (HBM) device that provides a high-speed computer memory interface for three-dimensional stacked synchronous dynamic random-access memory (SDRAM).

As further shown in Fig. 1C, the semiconductor package 100 may include one or more cable connection components 120, which may be disposed on the top surface of the first substrate 102. The one or more cable connection components 120 may be disposed on one or more portions (e.g., one or more non-central portions) of the top surface of the first substrate 102. The one or more cable connection components 120 may be electrically connected to the first substrate 102 (e.g., by flip-chip bonding and/or by wire bonding). A cable connection component 120 may include, for example a cable connector (e.g., a high-speed cable connector), that is configured to provide a connection (e.g., an input/output (IO) data connection, such as a high-speed IO data connection) with the at least one of the one or more semiconductor devices 118.

In some implementations, the semiconductor package 100 may be a lidless semiconductor package. In the lidless semiconductor package, the semiconductor device(s) 118 may be exposed to allow for direct contact between the semiconductor device(s) 118, and/or the cable connection component(s) 120, and a heatsink (not shown), thereby improving the thermal performance of the semiconductor package 100. Additionally, or alternatively, the semiconductor device(s) 118 and/or the cable connection component(s) 120 may be exposed to allow for direct connection (e.g., to other high-speed components).

As shown in Figs. 1A-1C, when the first substrate 102 is disposed on the second substrate 104 (e.g., laminated via the at least one bonding layer 116), the bottom surface of the first substrate 102 may not be disposed on (e.g., may not extend to be over) one or more portions of the top surface of the second substrate 104. That is, one or more portions of the top surface of the second substrate 104 may not be supporting the first substrate 102. Accordingly, as shown in Fig. 1C, the semiconductor package may include one or more power supply components 122, wherein a power supply component 122 is disposed on one of the one or more portions of the top surface of the second substrate 104 (e.g., on which the first substrate 102 and the at least one bonding layer 116 is not disposed), or on one or more top portions of a top surface of the at least one bonding layer 116 (e.g., on which the first substrate 102 is not disposed). The one or more power supply components 122 may be configured to receive electrical power, regulate the electrical power, and/or supply the electrical power to the second substrate 104. The electrical power then may transmit to the first substrate 102, such as via the one or more slots 108 and the one or more electrically conductive components 106. Accordingly, the first substrate 102 may provide the electrical power to the one or more semiconductor devices 118 (e.g., to operate the one or more semiconductor devices 118).

The one or more power supply components 122 may include one or more controllers, field-effect transistors (FETs), regulators, inductors, capacitors, clocks, and/or other power supply components. For example, one or more power supply components 122 may include a voltage converter to convert input electrical power voltage (e.g., a first voltage) to output electrical power voltage (e.g., a second voltage). Additionally, or alternatively, the one or more power supply components 122 may include a voltage regulator to maintain a constant voltage (e.g., supplied to the first substrate 102).

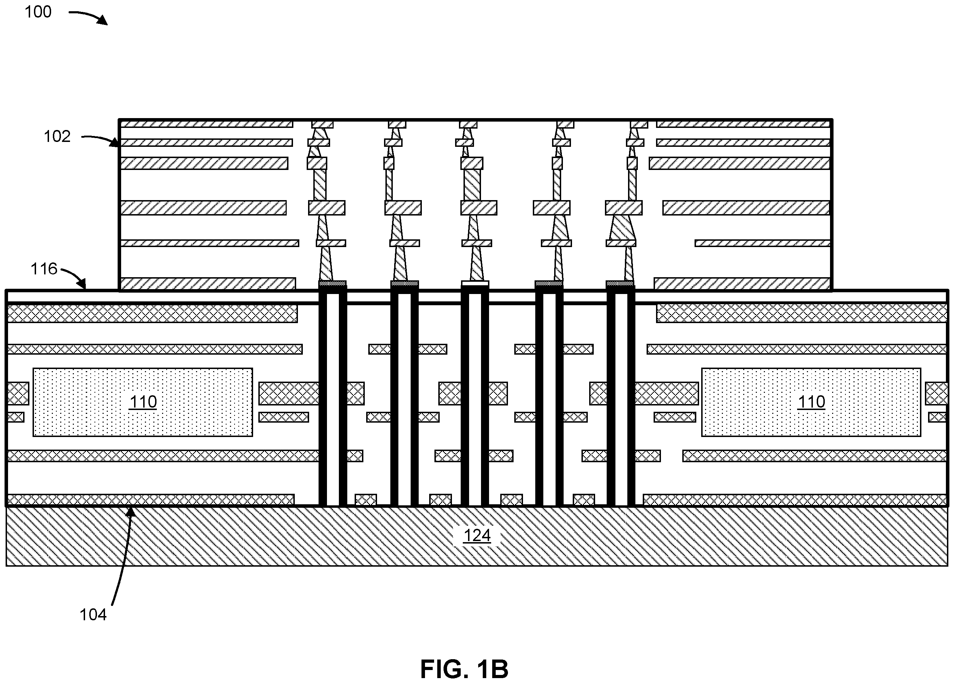

In some implementations, the semiconductor package 100 may include one or more heatsinks 124, which may be disposed on one or more surfaces of the second substrate 104. For example, as shown in Fig. 1B, a heatsink 124 may be disposed on the bottom surface of the second substrate 104. A heatsink 124 may be a passive heat exchanger that transfers heat generated by the semiconductor package 100 to a fluid medium (e.g., air, a liquid coolant, and/or another fluid medium). For example, the heatsink 124 may dissipate heat from the semiconductor package 100 to the surrounding air. The heatsink 124 may comprise a heat exchanging material that includes at least one copper, aluminum, or another type of heat exchanging material.

As indicated above, Figs. 1A-1E are provided as an example. Other examples may differ from what is described with regard to Figs. 1A-1E.

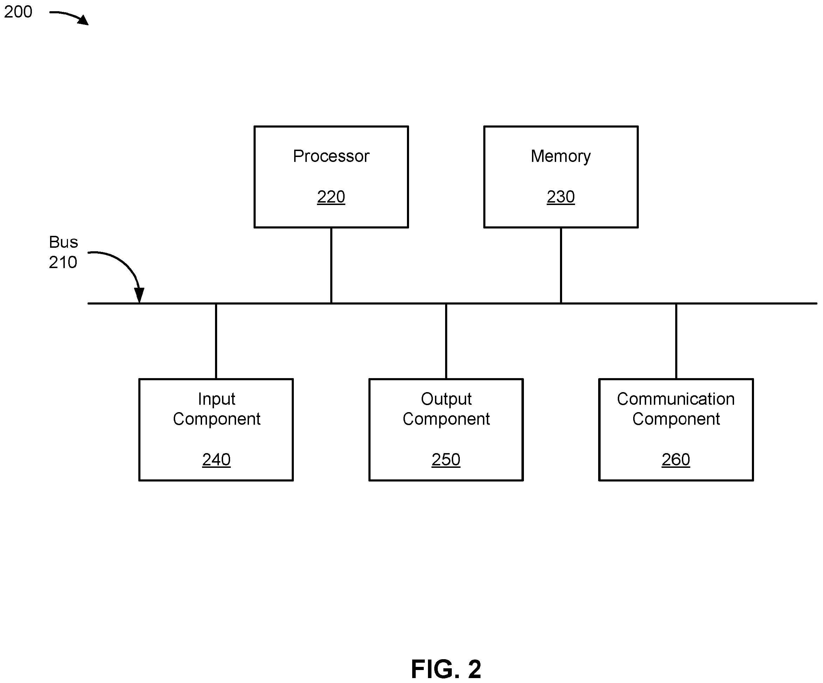

Fig. 2 is a diagram of example components of a device 200, which may correspond to the semiconductor package 100 and/or the semiconductor device 118. In some implementations, the semiconductor package 100 and/or the semiconductor device 118 may include one or more devices 200 and/or one or more components of the device 200. As shown in Fig. 2, the device 200 may include a bus 210, a processor 220, a memory 230, an input component 240, an output component 250, and/or a communication component 260.

The bus 210 may include one or more components that enable wired and/or wireless communication among the components of the device 200. The bus 210 may couple together two or more components of Fig. 2, such as via operative coupling, communicative coupling, electronic coupling, and/or electric coupling. For example, the bus 210 may include an electrical connection (e.g., a wire, a trace, and/or a lead) and/or a wireless bus. The processor 220 may include a central processing unit, a graphics processing unit, a microprocessor, a controller, a microcontroller, a digital signal processor, a field-programmable gate array, an application-specific integrated circuit, and/or another type of processing component. The processor 220 may be implemented in hardware, firmware, or a combination of hardware and software. In some implementations, the processor 220 may include one or more processors capable of being programmed to perform one or more operations or processes described elsewhere herein.

The memory 230 may include volatile and/or nonvolatile memory. For example, the memory 230 may include random access memory (RAM), read only memory (ROM), a hard disk drive, and/or another type of memory (e.g., a flash memory, a magnetic memory, and/or an optical memory). The memory 230 may include internal memory (e.g., RAM, ROM, or a hard disk drive) and/or removable memory (e.g., removable via a universal serial bus connection). The memory 230 may be a computer-readable medium. The memory 230 may store information, one or more instructions, and/or software (e.g., one or more software applications) related to the operation of the device 200. In some implementations, the memory 230 may include one or more memories that are coupled (e.g., communicatively coupled) to one or more processors (e.g., processor 220), such as via the bus 210. Communicative coupling between a processor 220 and a memory 230 may enable the processor 220 to read and/or process information stored in the memory 230 and/or to store information in the memory 230.

The input component 240 may enable the device 200 to receive input, such as user input and/or sensed input. For example, the input component 240 may include a touch screen, a keyboard, a keypad, a mouse, a button, a microphone, a switch, a sensor, a global positioning system sensor, an accelerometer, a gyroscope, and/or an actuator. The output component 250 may enable the device 200 to provide output, such as via a display, a speaker, and/or a light-emitting diode. The communication component 260 may enable the device 200 to communicate with other devices via a wired connection and/or a wireless connection. For example, the communication component 260 may include a receiver, a transmitter, a transceiver, a modem, a network interface card, and/or an antenna.

The device 200 may perform one or more operations or processes described herein. For example, a computer-readable medium (e.g., memory 230) may store a set of instructions (e.g., one or more instructions or code) for execution by the processor 220. The processor 220 may execute the set of instructions to perform one or more operations or processes described herein. In some implementations, execution of the set of instructions, by one or more processors 220, causes the one or more processors 220 and/or the device 200 to perform one or more operations or processes described herein. In some implementations, hardwired circuitry may be used instead of or in combination with the instructions to perform one or more operations or processes described herein. Additionally, or alternatively, the processor 220 may be configured to perform one or more operations or processes described herein. Thus, implementations described herein are not limited to any specific combination of hardware circuitry and software.

The number and arrangement of components shown in Fig. 2 are provided as an example. The device 200 may include additional components, fewer components, different components, or differently arranged components than those shown in Fig. 2. Additionally, or alternatively, a set of components (e.g., one or more components) of the device 200 may perform one or more functions described as being performed by another set of components of the device 200.

Thus, from one perspective, there has now been described a semiconductor package which includes a first substrate having a top surface and a bottom surface, and a second substrate having a top surface and a bottom surface. The bottom surface of the first substrate is connected to the top surface of the second substrate via at least one bonding layer. The first substrate includes one or more electrically conductive components arranged on the bottom surface of the first substrate in a first pattern. The second substrate includes one or more slots arranged on the bottom surface of the second substrate in a second pattern. The one or more slots are each plated with an electrically conductive material. The arrangement of the one or more electrically conductive components in the first pattern is aligned with the arrangement of the one or more slots in the second pattern. The second substrate includes a stiffener disposed within the second substrate.

The foregoing disclosure provides illustration and description, but is not intended to be exhaustive or to limit the implementations to the precise forms disclosed. Modifications and variations may be made in light of the above disclosure or may be acquired from practice of the implementations.

As used herein, satisfying a threshold may, depending on the context, refer to a value being greater than the threshold, greater than or equal to the threshold, less than the threshold, less than or equal to the threshold, equal to the threshold, not equal to the threshold, or the like.

As used herein, the term "component" is intended to be broadly construed as hardware, firmware, or a combination of hardware and software. It will be apparent that systems and/or methods described herein may be implemented in different forms of hardware, firmware, and/or a combination of hardware and software. The actual specialized control hardware or software code used to implement these systems and/or methods is not limiting of the implementations. Thus, the operation and behavior of the systems and/or methods are described herein without reference to specific software code - it being understood that software and hardware can be used to implement the systems and/or methods based on the description herein.

Even though particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set. As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiple of the same item.

No element, act, or instruction used herein should be construed as critical or essential unless explicitly described as such. Also, as used herein, the articles "a" and "an" are intended to include one or more items, and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of').

No element, act, or instruction used herein should be construed as critical or essential unless explicitly described as such. Also, as used herein, the articles "a" and "an" are intended to include one or more items, and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of'). Further, spatially relative terms, such as "below," "lower," "bottom," "above," "upper," "top," and the like, may be used herein for ease of description to describe one element or feature's relationship to another element(s) or feature(s) as illustrated in the figures. The spatially relative terms are intended to encompass different orientations of the apparatus, device, and/or element in use or operation in addition to the orientation depicted in the figures. The apparatus may be otherwise oriented (rotated 90 degrees or at other orientations) and the spatially relative descriptors used herein may likewise be interpreted accordingly.

Further examples of feature combinations taught by the present disclosure are set out in the following numbered clauses:
1. A semiconductor package, comprising:
   a first substrate having a top surface and a bottom surface; and
   a second substrate having a top surface and a bottom surface, wherein:
      the bottom surface of the first substrate is connected to the top surface of the second substrate via at least one bonding layer;
      the first substrate includes one or more electrically conductive components arranged on the bottom surface of the first substrate in a first pattern;
      the second substrate includes one or more slots arranged on the bottom surface of the second substrate in a second pattern,
      the one or more slots are each plated with an electrically conductive material; and
      the arrangement of the one or more electrically conductive components in the first pattern is aligned with the arrangement of the one or more slots in the second pattern.
2. The semiconductor package of clause 1, wherein the second substrate includes a stiffener disposed within the second substrate, and wherein:
   the stiffener is disposed within the second substrate and is aligned with a perimeter portion of the second substrate, and is not aligned with a central portion of the second substrate, and
   the one or more slots are arranged on the bottom surface of the second substrate and are aligned with the central portion of the second substrate, and are not aligned with the perimeter portion of the second substrate.
3. The semiconductor package of clause 1 or clause 2, wherein the bottom surface of the first substrate and the top surface of the second substrate are laminated together via the at least one bonding layer.
4. The semiconductor package of any preceding clause, wherein each of the one or more electrically conductive components of the first substrate and the electrically conductive material of the one or more slots comprises at least copper.
5. The semiconductor package of any preceding clause, wherein a semiconductor device is disposed on the top surface of the first substrate.
6. The semiconductor package of any preceding clause, wherein the bottom surface of the first substrate does not extend to be over a portion of the top surface of the second substrate.
7. The semiconductor package of clause 6, wherein at least one power supply component is disposed on the portion of the top surface of the second substrate.
8. The semiconductor package of any preceding clause, further comprising a heatsink disposed on the bottom surface of the second substrate.
9. The semiconductor package of any preceding clause, wherein the first substrate comprises a first set of materials and the second substrate comprises a second set of materials,
   wherein the first set of materials and the second set of materials are different.
10. A semiconductor package, comprising:
   a first substrate having a top surface and a bottom surface; and
   a second substrate having a top surface and a bottom surface, wherein:
      the bottom surface of the first substrate is connected to the top surface of the second substrate via at least one bonding layer;
      the second substrate includes one or more slots on the bottom surface of the second substrate,
         wherein each slot, of the one or more slots, extends through the second substrate and the at least one bonding layer;
      the one or more slots are each plated with an electrically conductive material; and
      the second substrate includes a stiffener disposed within the second substrate.
11. The semiconductor package of clause 10, wherein:
   the stiffener is disposed within the second substrate and is aligned with a perimeter portion of the second substrate, and
   the one or more slots are arranged on the bottom surface of the second substrate and are aligned with a central portion of the second substrate.
12. The semiconductor package of clause 10 or clause 11, wherein:
   the first substrate includes one or more electrically conductive components on the bottom surface of the first substrate that are aligned with the one or more slots on the bottom surface of the second substrate.
13. The semiconductor package of any of clauses 10 to 12, wherein the bottom surface of the first substrate does not extend to be over a portion of the top surface of the second substrate.
14. The semiconductor package of clause 13, wherein at least one power supply component is disposed on the portion of the top surface of the second substrate.
15. The semiconductor package of any of clauses 10 to 14, further comprising a heatsink disposed on the bottom surface of the second substrate.
16. A semiconductor package, comprising:
   a first substrate having a top surface and a bottom surface; and
   a second substrate having a top surface and a bottom surface, wherein:
      the bottom surface of the first substrate is connected to the top surface of the second substrate via at least one bonding layer;
      the second substrate includes one or more slots on the bottom surface of the second substrate that are each plated with an electrically conductive material; and
      the second substrate includes a stiffener disposed within the second substrate.
17. The semiconductor package of clause 16, wherein each slot, of the one or more slots, extends through the second substrate and through the at least one bonding layer.
18. The semiconductor package of clause 17, wherein the stiffener has an opening and at least one slot, of the one or more slots, extends through the opening of the stiffener.
19. The semiconductor package of any of clauses 16 to 18, wherein:
   the first substrate includes one or more electrically conductive components on the bottom surface of the first substrate that are electrically connected to the one or more slots of the second substrate.
20. The semiconductor package of any of clauses 16 to 19, further comprising a heatsink disposed on the second substrate.

## Claims

1. A semiconductor package, comprising:
a first substrate having a top surface and a bottom surface; and
a second substrate having a top surface and a bottom surface, wherein:
the bottom surface of the first substrate is connected to the top surface of the second substrate via at least one bonding layer;
the first substrate includes one or more electrically conductive components arranged on the bottom surface of the first substrate in a first pattern;
the second substrate includes one or more slots arranged on the bottom surface of the second substrate in a second pattern,
the one or more slots are each plated with an electrically conductive material; and
the arrangement of the one or more electrically conductive components in the first pattern is aligned with the arrangement of the one or more slots in the second pattern.

2. The semiconductor package of claim 1, wherein the second substrate includes a stiffener disposed within the second substrate, and wherein:
the stiffener is disposed within the second substrate and is aligned with a perimeter portion of the second substrate, and is not aligned with a central portion of the second substrate, and
the one or more slots are arranged on the bottom surface of the second substrate and are aligned with the central portion of the second substrate, and are not aligned with the perimeter portion of the second substrate.

3. The semiconductor package of claim 1 or claim 2, wherein the bottom surface of the first substrate and the top surface of the second substrate are laminated together via the at least one bonding layer.

4. The semiconductor package of any preceding claim, wherein each of the one or more electrically conductive components of the first substrate and the electrically conductive material of the one or more slots comprises at least copper.

5. The semiconductor package of any preceding claim, wherein a semiconductor device is disposed on the top surface of the first substrate.

6. The semiconductor package of any preceding claim, wherein the bottom surface of the first substrate does not extend to be over a portion of the top surface of the second substrate.

7. The semiconductor package of claim 6, wherein at least one power supply component is disposed on the portion of the top surface of the second substrate.

8. The semiconductor package of any preceding claim, further comprising a heatsink disposed on the bottom surface of the second substrate.

9. The semiconductor package of any preceding claim, wherein the first substrate comprises a first set of materials and the second substrate comprises a second set of materials,
wherein the first set of materials and the second set of materials are different.

10. A semiconductor package, comprising:
a first substrate having a top surface and a bottom surface; and
a second substrate having a top surface and a bottom surface, wherein:
the bottom surface of the first substrate is connected to the top surface of the second substrate via at least one bonding layer;
the second substrate includes one or more slots on the bottom surface of the second substrate,
wherein each slot, of the one or more slots, extends through the second substrate and the at least one bonding layer;
the one or more slots are each plated with an electrically conductive material; and
the second substrate includes a stiffener disposed within the second substrate.

11. The semiconductor package of claim 10, wherein:
the stiffener is disposed within the second substrate and is aligned with a perimeter portion of the second substrate, and
the one or more slots are arranged on the bottom surface of the second substrate and are aligned with a central portion of the second substrate.

12. The semiconductor package of claim 10 or claim 11, wherein:
the first substrate includes one or more electrically conductive components on the bottom surface of the first substrate that are aligned with the one or more slots on the bottom surface of the second substrate.

13. The semiconductor package of any of claims 10 to 12, wherein the bottom surface of the first substrate does not extend to be over a portion of the top surface of the second substrate, optionally wherein at least one power supply component is disposed on the portion of the top surface of the second substrate.

14. The semiconductor package of any of claims 10 to 13, further comprising a heatsink disposed on the bottom surface of the second substrate.

15. A semiconductor package, comprising:
a first substrate having a top surface and a bottom surface; and
a second substrate having a top surface and a bottom surface, wherein:
the bottom surface of the first substrate is connected to the top surface of the second substrate via at least one bonding layer;
the second substrate includes one or more slots on the bottom surface of the second substrate that are each plated with an electrically conductive material; and
the second substrate includes a stiffener disposed within the second substrate.
